# Europäisches Patentamt

# European Patent Office

# Office européen des brevets

(19)

(11) Veröffentlichungsnummer: **0 158 795**
**B1**

(12) ## EUROPÄISCHE PATENTSCHRIFT

(45) Veröffentlichungstag der Patentschrift:
**18.01.89**

(51) Int. Cl.⁴: **H 05 K 5/00**

(21) Anmeldenummer: **85102105.5**

(22) Anmeldetag: **26.02.85**

(54) Bedienungsfeld für elektrische und elektronische Geräte.

(30) Priorität: **03.04.84 DE 8410365 U**

(43) Veröffentlichungstag der Anmeldung:
**23.10.85 Patentblatt 85/43**

(45) Bekanntmachung des Hinweises auf die Patenterteilung:
**18.01.89 Patentblatt 89/3**

(84) Benannte Vertragsstaaten:
**DE FR GB IT SE**

(56) Entgegenhaltungen:
**DE-A- 2 713 307**
**DE-A- 2 902 052**
**GB-A- 2 086 804**

**IBM TECHNICAL DISCLOSURE BULLETIN, Band 5, Nr. 2, Juli 1962, Seiten 46-47, New York, US; A.T. HARDARDT et al: "Plastic component housing"**
**IDEM**

(73) Patentinhaber: **Nixdorf Computer Aktiengesellschaft, Fürstenallee 7, D-4790 Paderborn (DE)**

(72) Erfinder: **Knoop, Franz-Josef, Sonnenhang 7, D-4793 Büren-Steinhausen (DE)**
Erfinder: **Hardt, Walter, Hubertusweg 41, D-4790 Paderborn (DE)**

(74) Vertreter: **Schaumburg, Thoenes & Englaender, Mauerkircherstrasse 31 Postfach 86 07 48, D-8000 München 80 (DE)**

**Beschreibung**

Die Erfindung betrifft ein Bedienungsfeld für elektrische oder elektronische Geräte mit einer Vielzahl von Anzeige- und/oder Betätigungselementen, umfassend mindestens einen gitterförmigen Montagerahmen mit einer Vielzahl gleich grosser Gitteröffnungen zur Aufnahme der Anzeige und/oder Betätigungselemente, wobei diese jeweils ein mit Rastelementen versehenes Gehäuse aufweisen, das in eine Gitteröffnung des Montagerahmens einklipsbar ist.

Ein derartiges Bedienungsfeld hat den Vorteil, dass die Anzeige- und/oder Betätigungselemente aufgrund der Standardabmessungen ihrer Gehäuse auf vielfältige Weise und in unterschiedlichsten Anordnungen in den Montagerahmen eingesetzt werden können, wobei der Montagerahmen als Einheit zusammen mit den Anzeige- und/oder Betätigungselementen an einer Frontplatte eines Gehäuses montiert werden kann. Nicht benötigte Gitteröffnungen des Montagerahmens können durch geeignete Kappen abgedeckt werden.

Bei einer bekannten Ausführungsform werden die hinter der Frontplatte liegenden Montagerahmen derart an der Frontplatte angeschraubt, dass nur die Anzeige- und Bedienungselemente durch Öffnungen in der Frontplatte hindurchtreten. Der Erfindung liegt die Aufgabe zugrunde, die Montage des Bedienungsfeldes weiter zu vereinfachen und zu vereinheitlichen und auch bei unterschiedlichem Füllungsgrad der Montagerahmen mit Anzeige- und Betätigungselementen ein einheitliches Design des Bedienungsfeldes verschiedener Geräte zu ermöglichen.

Diese Aufgabe wird erfindungsgemäss dadurch gelöst, dass die Montagerahmen Rastelemente aufweisen, mit deren Hilfe sie in Rahmenöffnungen der Frontplatte des Gerätegehäuses einklipsbar sind.

Mit der erfindungsgemässen Lösung wird die Montage des Bedienungsfeldes weiter vereinfacht, da nach dem Einsetzen der Anzeige- und/oder Betätigungselemente in dem Montagerahmen und nach dem Verbinden der Elemente mit einer Leiterplatte die so gebildeten Baugruppen einfach in die Rahmenöffnungen der Frontplatte eingeklipst werden. Auf diese Weise entsteht ein Bedienungsmodul, der auch bei unterschiedlicher Bestückung mit Anzeige- und Betätigungselementen für verschiedene Geräte ein einheitliches Erscheinungsbild bietet. Vorzugsweise sind die Rahmenöffnungen zumindest gleich breit ausgebildet, so dass nur eine einzige Ausführungsform der Montagerahmen benötigt wird. Für die nicht benötigten Rahmenöffnungen können Abdeckelemente vorgesehen sein, die ebenfalls wie die Montagerahmen mit Rastelementen in die Rahmenöffnungen einklipsbar sind. Damit können die nicht benötigten Rahmenöffnungen abgedeckt werden, ohne dass sich das gesamte Erscheinungsbild des Bedienungsfeldes wesentlich ändert. Gleichzeitig können die Abdeckungen als Träger für Typenbezeichnungen, Namen und dgl. ausgebildet sein.

Die Rastelemente an den Montagerahmen und/oder Abdeckelementen sind vorzugsweise jeweils einstückig mit den Montagerahmen bzw. Abdeckelementen in Form von Rastnasen oder Rastklingen ausgebildet, welche im eingebauten Zustand der Montagerahmen bzw. Abdeckelemente eine die Rahmenöffnung umgebende Innenkante der Frontplatte hintergreifen, während sich die Montagerahmen und die Abdeckelemente an der Aussenseite eines die Rahmenöffnungen umgebenden Randes abstützen. Dadurch wirken die Montagerahmen gleichzeitig als Blendrahmen, sodass beispielsweise eine gesonderte Umrandung des aus den Anzeigeelementen und Betätigungselementen eines Montagerahmens gebildeten Teilfeldes entfällt und die Schlitze zwischen den Anzeige- und/oder Betätigungselementen und dem Rand der Rahmenöffnungen abgedeckt sind. Dadurch wird einerseits das Erscheinungsbild des Bedienungsfeldes verbessert und andererseits das Eindringen von Staub an diesen Schlitzen verhindert. Dies gilt insbesondere für den Fall, dass einzelne Gitteröffnungen der Montagerahmen nicht mit Anzeige- oder Betätigungselementen bestückt, sondern nur von Blindkappen abgedeckt sind.

Vorzugsweise sind die die Rahmenöffnungen in der Frontplatte umgebenden Rändern derart versenkt, dass die Aussenflächen der Montagerahmen bzw. Abdeckelemente in eingebautem Zustand bündig mit der Aussenfläche der Frontplatte abschliessen.

Weitere Merkmale und Vorteile der Erfindung ergeben sich aus der folgenden Beschreibung, welche in Verbindung mit den beigefügten Zeichnungen die Erfindung anhand eines Ausführungsbeispieles erläutert. Es zeigen:

Fig. 1 Eine perspektivische Draufsicht auf den gesamten Bedienungsmodul, wobei eine Rahmenöffnung eines Frontrahmens freigelassen und ein Abdeckelement einer Rahmenöffnung teilweise weggebrochen wurde,

Fig. 2 einen Schnitt durch den Bedienungsmodul längs Linie II–II in Fig. 1,

Fig. 3 eine teilweise geschnittene perspektivische Ansicht durch einen Montagerahmen allein und

Fig. 4 eine teilweise geschnittene perspektivische Ansicht durch ein Abdeckelement allein.

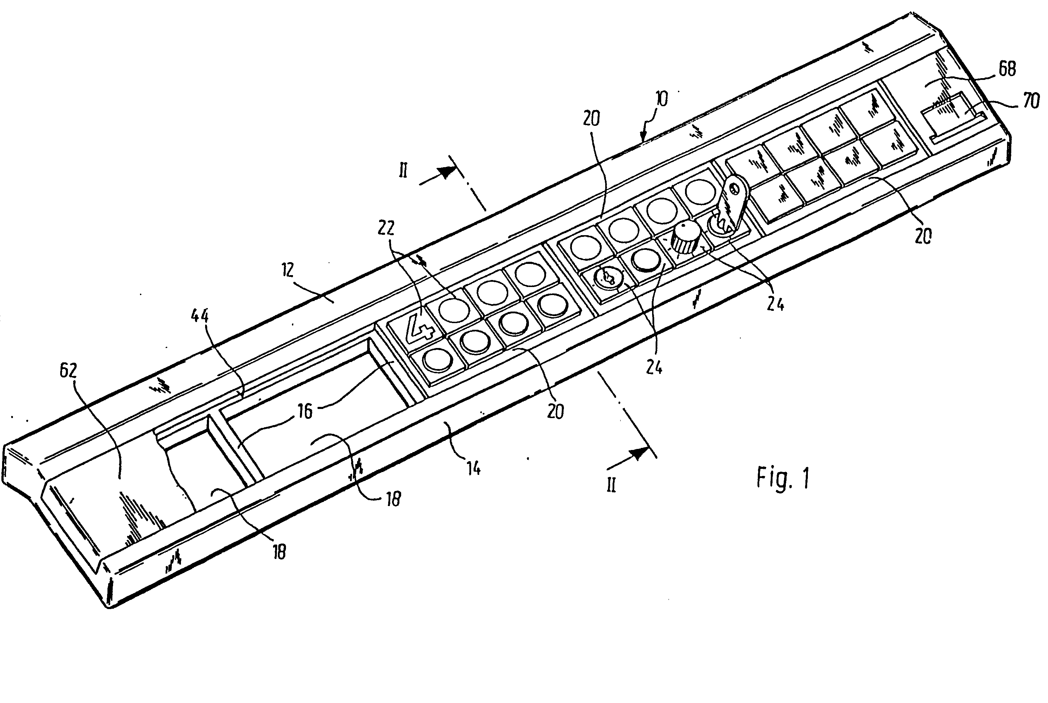

Der in Fig. 1 dargestellte Bedienungsmodul umfasst einen allgemein mit 10 bezeichneten Frontrahmen, der in nicht dargestellter Weise mit dem Gehäuse eines elektrischen oder elektronischen Geräts verbunden werden kann. Der Frontrahmen 10 ist so geformt, dass nach seinem Einbau in das Gerätegehäuse das Bedienungsfeld pultförmig geneigt ist.

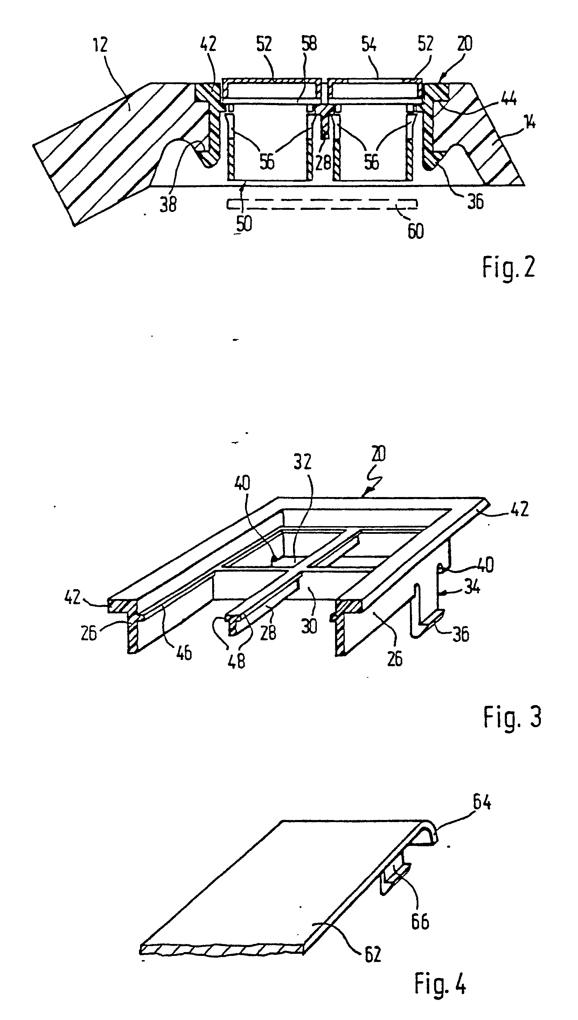

Der Frontrahmen 10 besteht aus zwei breiten Längsseiten 12 und 14, die durch Querstege 16 miteinander verbunden sind, so dass eine Reihe von Rahmenöffnungen 18 entsteht, von denen in der Fig. 1 nur zwei zu erkennen sind. Zumindest die Abmessung der Rahmenöffnungen quer zur Längsrichtung des Frontrahmens 10 ist gleich gross und zur Aufnahme jeweils eines Montagerahmens (20) (Fig. 3) bestimmt. Der Montagerahmen 20 seinerseits ist zur Aufnahme und Halterung von Anzeigeelementen 22 und Betätigungselementen 24 ausgebildet.

Der rechteckige Montagerahmen 20 besteht aus äusseren Rahmenholmen 26, zwischen denen mittels eines oder mehrerer Längsstege 28 und einer Mehrzahl von Querstegen 30 ein Rahmengitter mit quadratischen Gitteröffnungen 32 gebildet ist. Die äusseren Rahmenholme 26 und die Stege 28 und 30 sind vorzugsweise einstückig aus Kunststoff hergestellt.

An den langen Rahmenholmen 26 sind einstückig mit diesen nach unten abstehende Rastklinken 34 ausgebildet, von denen in der Figur 3 nur eine dargestellt ist. Die Rastklinken 34 untergreifen in eingebautem Zustand des Montagerahmens mit ihrer Rastnase 36 eine die Rahmenöffnung 18 umgebende Haltefläche 38 an dem Frontrahmen 10 (Fig. 2). Um die Elastizität der Rastklinke 34 zu erhöhen und damit das Einsetzen des Montagerahmens 20 in den Frontrahmen 10 zu erleichtern, ist der Stiel der Rastklinke 34 durch Einschnitte 40 in den Rahmenholmen 26 verlängert.

An ihrer Oberseite weisen die Rahmenholme 26 einen nach aussen abstehenden Rand 42 auf, der einen Blendrahmen bildet und zur Auflage auf einem die Rahmenöffnungen 18 in dem Frontrahmen 10 umgebenden Stufenfalz 44 bestimmt ist, wobei die Dicke des Rahmens 42 und die Tiefe des Stufenfalzes 44 so aufeinander abgestimmt sind, dass nach dem Einsetzen der Montagerahmen 20 in den Frontrahmen 10 die Oberseite der Montagerahmen 20 mit der Oberseite des Frontrahmens 10 fluchtet, wie dies in Figur 2 zu erkennen ist.

An der Innenseite der Rahmenholme 26 ist in Höhe der Oberkanten der Stege 28 und 30 eine schmale umlaufende Leiste 46 ausgeformt die zusammen mit Leisten 48 gleichen Querschnittes an dem Längssteg 28 zur Halterung der in den Montagerahmen 20 eingesetzten Anzeige- und Betätigungselemente 22 bzw. 24 dient. Die eigentlichen Anzeigenelemente und Betätigungselemente sind nicht dargestellt. Sie sind jeweils in einem Gehäuse 50 mit quadratischem Querschnitt angeordnet, das nach oben hin durch eine Blendenkappe 52 verschlossen ist, die ein Fenster oder eine Durchtrittsöffnung 54 für das Betätigungselement aufweisen kann, wie dies in Figur 2 zu erkennen ist.

Durch nicht dargestellte Ausnehmungen sind in zwei einander gegenüberliegenden Gehäusewänden Rastzungen 56 gebildet, die nach dem Einsetzen des Gehäuses 50 in eine Gitteröffnung 32 die Leisten 46 bzw. 48 untergreifen, wie man in Figur 2 erkennt. Auf der Oberseite der Leisten 46 bzw. 48 liegen die Gehäuse 50 mit einem Rand 58 auf, der bündig mit der Blendenkappe 52 abschliesst. Diese kann in an sich bekannter Weise mit dem Gehäuse 50 durch Rastmittel verbunden sein.

Bei der Montage des Bedienungsmoduls werden zunächst sämtliche Anzeigeelemente 22 und Betätigungselemente 24 in der gewünschten Anordnung in einen Montagerahmen 20 eingesetzt und in der vorstehend beschriebenen Weise verrastet. Anschliessend werden die Anschlüsse der in den Gehäusen 50 untergebrachten Elemente mit einer Leiterplatte 60 verlötet, die durch gestrichelte Linien in Figur 2 angedeutet ist. Die so gebildete Baugruppe kann nun in eine Rahmenöffnung 18 eingesetzt und mit Hilfe der Rastklinken 34 in dem Frontrahmen 10 verrastet werden. Wie man in Figur 1 erkennt, decken im eingesetzten Zustand die Ränder 42 der Montagerahmen 20 die Fugen zwischen den Montagerahmen und den die Rahmenöffnungen 18 umgebenden Teilen des Frontrahmens 10 vollständig ab, sodass sich ein geschlossenes Bedienungsfeld umgibt.

Die nicht benötigten Gitteröffnungen 32 der Montagerahmen 20 können durch Blindkappen verschlossen werden, die entsprechend den Gehäusen 50 der Anzeige- und Betätigungselemente mit Rastelemente versehen sind.

Rahmenöffnungen 18, in die kein Montagerahmen 20 eingesetzt werden soll, können mit einem Abdeckelement 62 abgedeckt werden, wie es in Figur 4 dargestellt ist. Bei der dort dargestellten Ausführungsform handelt es sich um ein Randelement, dass mit einem gebogenen Randabschnitt 64 eine Endkante des Frontrahmens 10 übergreift, wie dies in Figur 1 zu erkennen ist. Das Abdeckelement 62 weist an seiner Unterseite den Rastklinken 34 entsprechende Rastelemente 66 auf, mit denen es im Frontrahmen 10 verrastet werden kann. Die Abdeckelemente 62 können in geeigneter Weise als Träger für Typenbezeichnungen Namen oder dergleichen ausgebildet sein, wie man dies beispielsweise für das in Figur 1 am rechten Ende des Frontrahmens 10 dargestellte Abdeckelement 68 erkennt. Dieses weist ein vertieftes Schriftfeld 70 auf, in das ein geeignetes Schrifttäfelchen, Schild oder dergleichen eingeschoben werden kann.

Die vorstehende Beschreibung zeigt, dass der erfindungsgemässe Bedienungsmodul äusserst einfach zu montieren ist. Ist es erforderlich, Anzeigeelemente oder Betätigungselemente zu entfernen, auszutauschen oder zu ergänzen, ist das Herausnehmen der Montagerahmen aus dem Frontrahmen 10 äusserst einfach. Die Rastklinken 34 werden nach innen gedrückt und der Montagerahmen 20 nach aussen aus den Rastöffnungen 13 herausgedrückt. Nach dem Entlöten der Anschlüsse der Anzeigeelemente und Betätigungselemente können diese unter Eindrücken der Rastzungen 56 ebenfalls aus dem jeweiligen Montagerahmen 20 herausgenommen werden.

## Patentansprüche

1. Bedienungsfeld für elektrische oder elektronische Geräte mit einer Vielzahl von Anzeigen- und/oder Betätigungselementen, umfassend mindestens einen gitterförmigen Montagerahmen mit einer Vielzahl gleich grosser Gitteröffnungen zur Aufnahme der Anzeige- und/oder Betätigungselemente, wobei diese jeweils ein mit Rastelementen versehenes Gehäuse aufweisen, das in eine Gitteröffnung des Montagerahmens einklipsbar ist, dadurch gekennzeichnet, dass die Montagerahmen (20) weitere Rastelemente (34) aufweisen, mit deren Hilfe sie in Rahmenöffnungen (18) einer Frontplatte (10) eines Gerätegehäuses einklipsbar sind.

2. Bedienungsfeld nach Anspruch 1, dadurch gekennzeichnet, dass die Frontplatte an einem mit dem Gerätegehäuse verbindbaren Frontrahmen (10) ausgebildet ist.

3. Bedienungsfeld nach Anspruch 1 oder 2, dadurch gekennzeichnet, dass den Rahmenöffnungen (18) mit Rastelementen (66) versehene Abdeckelemente (62, 68) zugeordnet sind.

4. Bedienungsfeld nach Anspruch 3, dadurch gekennzeichnet, dass die Rastelemente (34) an den Montagerahmen (20) und/oder Abdeckelementen (62, 68) jeweils von einstückig mit den Montagerahmen (20) bzw. Abdeckelementen (62, 68) ausgebildeten Rastnasen (36) gebildet sind, welche im eingebauten Zustand der Montagerahmen (20) bzw. Abdeckelementen (62, 68) eine die Rahmenöffnungen (18) umgebende Innenkante (38) der Frontplatte (10) hintergreifen, während sich die Montagerahmen (20) und die Abdeckelemente (62, 68) an der Aussenseite eines die Rahmenöffnungen (18) umgebenden Randes (44) abstützen.

5. Bedienungsfeld nach Anspruch 4, dadurch gekennzeichnet, dass die die Rahmenöffnungen (18) in der Frontplatte (10) umgebenden Ränder (44) derart versenkt sind, dass die Aussenflächen der Montagerahmen (20) bzw. Abdeckelemente (62, 68) im eingebauten Zustand bündig mit der Aussenfläche der Frontplatte (10) abschliessen.

6. Bedienungsfeld nach einem der Ansprüche 1 bis 5, dadurch gekennzeichnet, dass die Gehäuse (50) für die Anzeige- und Betätigungselemente jeweils eine abnehmbare Blendkappe (52) aufweisen, die mit einem Gehäusesockel durch Rastmittel verbindbar ist und mindestens ein Fenster und/ oder eine Durchtrittsöffnung (54) für ein Anzeigeelement bzw. ein Betätigungselement aufweist.

## Claims

1. A control panel for electric or electronic appliances having a large number of indicating and/ or control elements and comprising at least one lattice-like assembly frame formed with a large number of lattice apertures which are all of the same size and which are adapted to receive the indicating and/or control elements, each of the same having a casing which has catching or latching elements and which can be clipped into a lattice aperture in the frame, characterised in that the assembly frames (20) have further catching or latching elements (34) enabling them to be clipped into frame apertures (18) in a front plate (10) of an appliance casing.

2. A control panel according to claim 1, characterised in that the front panel is formed on a front frame (10) connectable to the appliance casing.

3. A control panel according to claim 1 or 2, characterised in that cover elements (62, 68) having catching or latching elements (66) are associated with the frame apertures (18).

4. A control panel according to claim 3, characterised in that the catching or latching elements (34) on the assembly frames (20) and/or cover elements (62, 68) are in the form of catching or latching projections (36) unitary with such frames (20) and elements (62, 68), the projections (36) engaging, with the assembly frames (20) or cover elements (62, 68) assembled, behind an inside edge (38) of the front plate (10), the inside edge (38) extending around the frame apertures (18), while the frames (20) and cover elements (62, 68) bear on the outside of an edge (44) extending aroung the frame apertures (18).

5. A control panel according to claim 4, characterised in that the edges which extend around the frame apertures (18) in the front plate are so recessed that the outside surfaces of the frames (20) or cover elements (62, 68) terminate flush with the front plate outside surface in the assembled state.

6. A control panel according to any of claims 1–5, characterised in that the casings (50) for the indicating and control elements each have a removable masking cap (52) which can be connected by catching or latching means to a casing base and which has at least one window and/or passage (54) for an indicating element or a control element.

## Revendications

1. Clavier de commande pour appareils électriques ou électroniques, comportant une pluralité d'éléments de signalisation et/ou d'actionnement, comprenant au moins un châssis de montage en forme de quadrillage présentant une pluralité d'ouvertures de quadrillage de même dimension pour la réception des éléments de signalisation et/ou d'actionnement, ceux-ci comportant chacun un boîtier pourvu d'éléments d'encliquetage, qui peut être enclipsé dans une ouverture de quadrillage du châssis de montage, caractérisé en ce que les châssis de montage (20) comportent d'autres éléments d'encliquetage (34) à l'aide desquels ils peuvent être enclipsé dans des ouvertures de châssis (18) d'un panneau frontal (10) d'un boîtier d'appareil.

2. Clavier selon la revendication 1, caractérisé en ce que le panneau frontal est formé sur un châssis frontal (10) pouvant être relié au boîtier d'appareil.

3. Clavier selon la revendication 1 ou 2, caractérisé en ce que des éléments de couvercle (62, 68) pourvus d'éléments d'encliquetage (66) sont adjoints aux ouvertures (18) de châssis.

4. Clavier selon la revendication 3, caractérisé en ce que les éléments d'encliquetage (34) sont, sur les châssis de montage (20) et/ou les éléments de couvercle (62, 68) constitués chacun par des ergots d'encliquetage (36) faits d'une pièce avec les châssis de montage (20) ou les éléments de couvercle (62, 68), lesquels ergots s'engagent, dans l'état monté des châssis de montage (20) ou des éléments de couvercle (62, 68) derrière une arête intérieure (38) du panneau frontal (10) entourant les ouvertures (18) de châssis, tandis que le châssis de montage (20) et les éléments de couvercle (62, 68) s'appuient sur le côté extérieur d'un rebord (44) entourant les ouvertures (18) de châssis.

5. Clavier selon la revendication 4, caractérisé en ce que les rebords (44) entourant les ouvertures (18) de châssis dans le panneau frontal (10) sont situés en retrait de telle façon que les surfaces extérieures des châssis de montage (20) ou des éléments de couvercle (62, 68) se raccordent, dans l'état monté, en coïncidant avec la surface extérieure du panneau frontal (10).

6. Clavier selon l'une des revendications 1 à 5, caractérisé en ce que les boîtiers (50) pour les éléments de signalisation et d'actionnement comportent chacun un cache amovible (52) qui peut être relié à un socle de boîtier par des moyens d'encliquetage et comporte au moins une fenêtre et/ou une ouverture de passage (54) pour un élément de signalisation ou un élément d'actionnement.

Fig. 1

EP 0 158 795 B1

Fig. 2

Fig. 3

Fig. 4